# FASCICULE DE BREVET EUROPEEN

(11) **EP 1 148 304 B1**
(45) Date de publication et mention de la délivrance du brevet: **08.12.2004**
(21) Numéro de dépôt: 01400752.0
(22) Date de dépôt: 23.03.2001
(51) Int. Cl.: F24H 9/20

(54) **Dispositif électronique de gestion de chauffe-eau électrique**
Elektronische Regler für einen elektrischen Wasserheizer
Electronic control device for an electric water heater

(30) Priorité: 17.04.2000 FR 0004898
(43) Date de publication de la demande: 24.10.2001
(73) Titulaire: Atlantic Industrie, 85000 La Roche sur Yon (FR)
(72) Inventeur: Bony, Yves, 85170 Dompierre sur Yon (FR)
(74) Mandataire: Kaspar, Jean-Georges

(56) Documents cités:
- EP-A- 0 933 602
- US-A- 4 449 091
- US-A- 5 083 011

## Description

L'invention est relative à un dispositif de gestion électronique pour chauffe-eau électrique à accumulation.

Pour assurer simultanément la régulation thermostatique et le déclenchement en sécurité de l'alimentation électrique d'une résistance de chauffage d'un chauffe-eau électrique à accumulation, assurer la protection cathodique de la cuve du chauffe-eau électrique à accumulation, et éventuellement alimenter sélectivement la résistance du chauffe-eau en fonction des modulations tarifaires appliquées par la compagnie productrice d'électricité, le document FR 2.774.153 enseigne l'utilisation d'une carte électronique principale attachée directement ou indirectement à la cuve du chauffe-eau et assurant à la fois la protection cathodique et un fonctionnement sélectif de l'alimentation électrique en fonction des modulations tarifaires appliquées par un producteur d'électricité, tout en procurant la régulation thermostatique et le déclenchement en sécurité de l'alimentation de la résistance de chauffage du chauffe-eau électrique.

Le document FR 2.774.153 décrit trois modes de réalisation d'un dispositif de gestion électronique pour chauffe-eau électrique à accumulation : deux modes de réalisation conçus pour une alimentation monophasée et un mode de réalisation conçu pour une alimentation triphasée.

La multiplicité des variantes de dispositif de gestion électronique entraîne la nécessité de stocks importants de chauffe-eau électriques à accumulation pour répondre à des besoins différents et des types d'alimentation électrique différents.

Le niveau élevé des stocks de chauffe-eau électriques à accumulation correspondant à ces diverses variantes entraîne des coûts de fabrication et de stockage indésirables.

L'invention a pour but de remédier aux inconvénients à la technique connue, en simplifiant l'agencement des chauffe-eau électriques à accumulation, de manière à réduire le nombre de références de production chez le fabricant, ainsi que le nombre d'appareils de références différentes à stocker chez un grossiste, un installateur ou un vendeur de chauffe-eau électrique à accumulation.

L'invention a pour objet un dispositif électronique de gestion de chauffe-eau électrique à accumulation, comportant une carte électronique principale; une carte électronique de mesure apte à être insérée dans un doigt de gant d'un chauffe-eau auquel le dispositif est destiné, caractérisé en ce que le dispositif comporte, en combinaison, une carte électronique secondaire comprenant des moyens de raccordement à une alimentation électrique triphasée, des moyens de transformation de ladite alimentation électrique triphasée en une alimentation électrique monophasée, et des moyens de connexion à une carte électronique principale reliée à la carte électronique de mesure, de manière à alimenter la carte électronique principale en lui délivrant ladite alimentation électrique monophasée.

Selon d'autres caractéristiques de invention :
- les moyens de connexion sont agencés et prédéterminés pour permettre le placage de la carte électronique principale et de la carte secondaire l'une contre l'autre ;
- la carte secondaire comporte des relais de commande d'alimentation triphasée de la résistance de chauffage ou du corps de chauffe d'un chauffe-eau électrique à accumulation auquel la carte est destinée ;
- lesdits relais de commande d'alimentation triphasée sont des relais pilotés par un ou plusieurs signaux de commande émis par la carte électronique principale ;
- la carte électronique principale comporte un fusible supplémentaire de protection solidarisé à la carte, pour assurer une protection supplémentaire à la protection assurée par un fusible principal remplaçable ;
- la carte électronique principale comporte un bloc formant contacteur jour/nuit apte à être commandé par un fil pilote.

L'invention sera mieux comprise grâce à la description qui va suivre donnée à titre d'exemple non limitatif en référence aux dessins annexés dans lesquels :
- la figure 1 représente schématiquement une vue de dessus d'un agencement fonctionnel d'un mode de réalisation de l'invention, dans une position déployée ;
- la figure 2 représente schématiquement une vue en perspective d'un agencement fonctionnel d'un mode de réalisation de l'invention en position compacte ;
- la figure 3 représente schématiquement un circuit électronique représentatif d'une carte de dispositif électronique selon invention ;
- la figure 4 représente schématiquement un circuit électronique correspondant à l'agencement fonctionnel de l'invention.

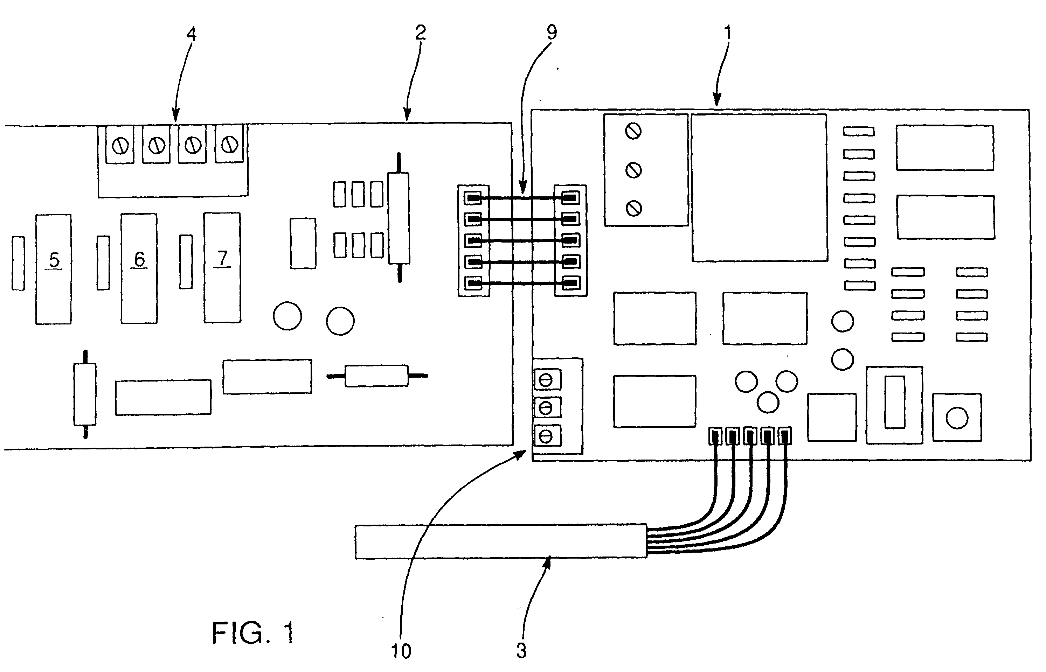

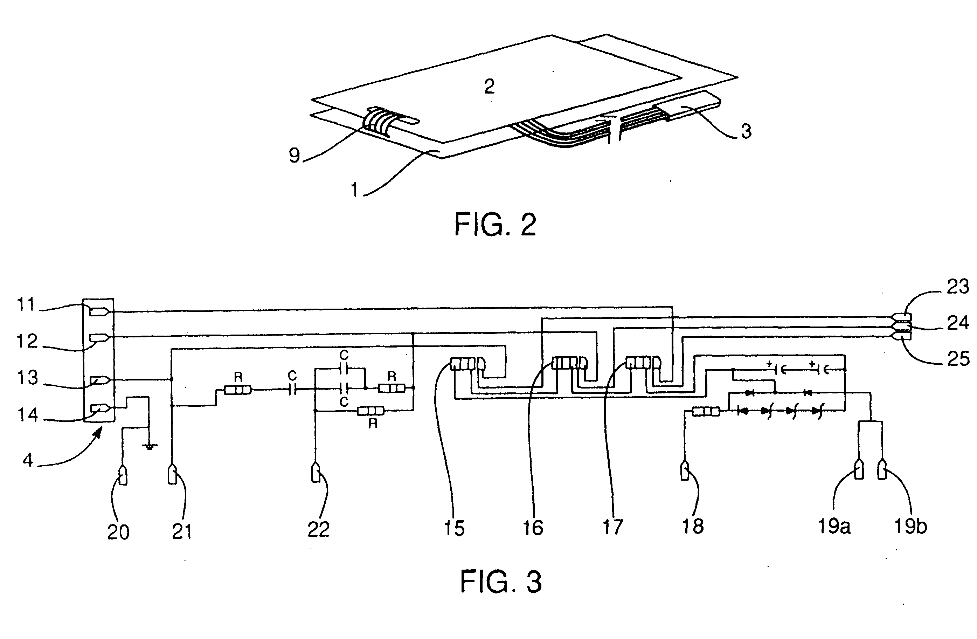

En référence aux figures 1 et 2, les éléments identiques ou fonctionnellement équivalents sont repérés par des chiffres de références identiques.

Selon l'invention, le dispositif électronique de gestion de chauffe-eau électrique à accumulation comporte une carte 1 électronique principale et une carte électronique 2 secondaire, ainsi qu'une troisième carte 3 électronique de mesure de dimensions prédéterminées pour l'insertion dans un doigt de gant de faible diamètre d'un chauffe-eau électrique.

De préférence, la carte 3 électronique de mesure présente des dimensions prédéterminées permettant l'insertion dans un cylindre de diamètre voisin du centimètre. La carte 3 électronique de mesure comporte un capteur de température à semi-conducteur pour la régulation, un capteur à coefficient de température positif (CTP) pour régler un premier niveau de déclenchement en sécurité et un capteur au silicium pour régler un deuxième niveau de déclenchement en sécurité ; ces trois capteurs de type connu n'étant pas représentés plus en détail.

La carte électronique 1 principale, est apte à fonctionner en alimentation monophasée et est conçue pour assurer les fonctions de régulation thermostatique ajustable, de déclenchement en sécurité omnipolaire, de protection cathodique de la cuve du chauffe-eau par anodes à courant imposé, de contacteurs d'alimentation de puissance pour plages tarifaires et de coupure de l'alimentation de la résistance de chauffage en cas d'insuffisance de niveau d'eau dans la cuve du chauffe-eau. La carte électronique 1 principale est similaire aux cartes de gestion électronique pour chauffe-eau électrique à accumulation décrites dans le document FR 2.774.153.

La carte électronique 2 secondaire est prévue pour recevoir une alimentation triphasée en 400 volts et comporte trois relais de puissance 5, 6, 7. La carte 2 secondaire est prédéterminée pour transformer l'alimentation triphasée arrivant par le bloc de connexion 4 en une alimentation monophasée apte à être utilisée pour alimenter la carte principale 1. A cet effet, on prévoit des liaisons filaires 9 pour relier la carte secondaire 2 d'alimentation à la carte principale 1 de gestion électronique.

La carte 1 électronique principale comporte également un accumulateur d'énergie électrique pour assurer le débit de courant nécessaire à la protection cathodique permanente de la cuve, lors des périodes dans lesquelles le chauffe-eau n'est plus alimenté électriquement, ces périodes correspondant aux plages tarifaires appelées "heures pleines" par la compagnie productrice d'électricité. Un dispositif de limitation de charge et de limitation de décharge de cet accumulateur d'énergie électrique est également présent sur la carte 1 électronique principale.

Un fusible de coupure de l'alimentation de puissance de la résistance de chauffe est prévu sur la carte 1 électronique principale, ce fusible permettant toutefois l'alimentation de la carte électronique 1 principale, pour assurer en permanence la continuité de la protection cathodique de la cuve de chauffe-eau. Des diodes électroluminescentes sont avantageusement prévues pour indiquer, respectivement,. l'état de l'accumulateur générant le courant de protection cathodique, et l'alimentation de la résistance de chauffage du chauffe-eau

Grâce à l'invention, il est possible d'utiliser constamment une carte électronique 1 principale associée à une carte 3 électronique de mesure, en l'alimentant directement par une alimentation électrique monophasée arrivant sur le bloc de connexion 10 prévu sur la carte électronique 1 principale.

Lorsque l'alimentation électrique disponible est une alimentation électrique triphasée, on établit les liaisons filaires 9 entre la carte 1 principale et la carte secondaire 2, de manière à alimenter la carte secondaire 2 grâce à l'alimentation électrique triphasée arrivant par le bloc de connexion 4, puis à transformer cette alimentation électrique triphasée en alimentation monophasée transitant par les liaisons filaires 9 pour alimenter la carte électronique 1 principale.

Ainsi, les chauffe-eau électriques selon l'invention peuvent constamment être conçus pour comporter à demeure une carte électronique 1 principale et une carte électronique de mesure 3. En fonction de la nature de l'alimentation, on prévoit d'ajouter ou non une carte secondaire 2 apte à être alimentée en tension triphasée.

Cette disposition de l'invention permet ainsi de réduire les stocks et facilite la mise en oeuvre des chauffe-eau électriques selon l'invention, car l'installateur a besoin de prévoir uniquement la mise en place éventuelle d'une carte secondaire 2, pour réaliser l'adaptation à une alimentation électrique triphasée.

Avantageusement, sur la figure 2, le dispositif est prévu pour que les cartes principale 1 et secondaire 2 se plaquent l'une contre l'autre, ceci étant rendu possible dans cet exemple de réalisation par la souplesse des liaisons électriques 9 entre la carte principale 1 et la carte secondaire 2 d'adaptation triphasée.

Cette disposition permet la mise en place dans le boîtier de réception solidaire de la cuve du chauffe-eau, de sorte qu'aucune modification mécanique n'est à entreprendre pour alimenter un chauffe-eau en alimentation monophasée ou en alimentation triphasée, selon le cas.

Cependant, d'autres dispositions peuvent être envisagées sans sortir du cadre de la présente invention : ainsi, les moyens 9 de connexion peuvent être rigides, tout en assurant le placage des cartes 1 et 2 l'une contre l'autre. A titre d'exemple, ces moyens 9 de connexion peuvent comprendre des connecteurs à broches ou d'autres systèmes à conducteurs rigides, montés respectivement sur la carte 1 et sur la carte 2 de manière à permettre une connexion par un assemblage de sens transversal ou perpendiculaire aux plans des cartes 1 et 2.

En référence à la figure 3, un circuit électronique d'une carte secondaire 2 est représenté. Le bloc de connexion 4 comporte quatre bornes de connexion 1 à 14 : les bornes 11 à 13 correspondent aux trois phases d'une alimentation triphasée, tandis que la borne 14 correspond à la terre et est reliée à la masse commune du chauffe-eau électrique non représenté. Les trois phases 11 à 13 sont reliées à des relais électriques 15 à 17, aptes à être pilotés par des tensions de commande sur des bornes 18, 19a, 19b.

La connexion 14 de terre correspondant à la masse du chauffe-eau est reliée à une connexion 20 de terre de la carte électronique 1 principale non représentée, les phases 12 et 13 sont adaptées pour fournir des tensions monophasées sur les connexions 21 et 22 de la carte électronique 1 principale non représentée.

Des connexions supplémentaires éventuelles 23 à 25 sont prévues pour l'alimentation du corps de chauffe ou résistance de chauffage du chauffe-eau électrique à accumulation, cette alimentation étant établie au travers des relais électriques commandables 15 à 17.

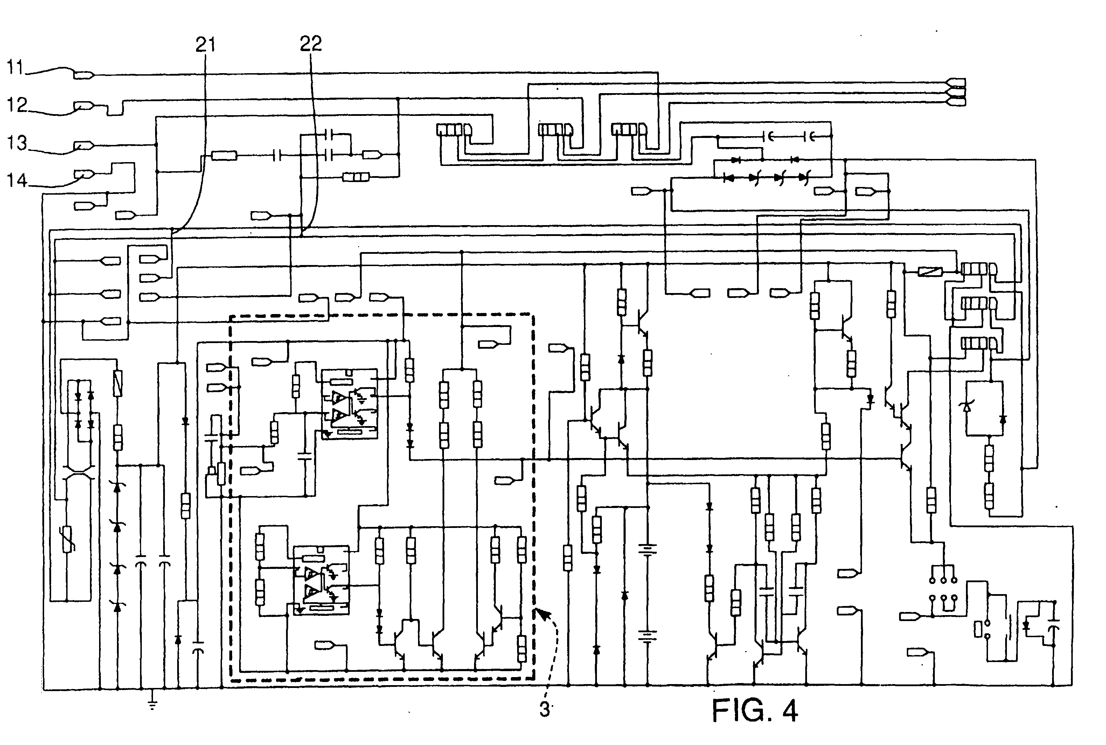

En référence à la figure 4, un circuit électronique d'un dispositif selon l'invention correspondant à la figure 1 ou à la figure 2 est représenté. Ce dispositif comporte un sous-ensemble constitué par la carte secondaire 2 de transformation de l'alimentation triphasée arrivant sur les bornes 11 à 14, de manière à fournir une alimentation monophasée au sous-ensemble constitué par la carte électronique 1 principale.

La carte monophasée principale 1 comporte un bloc d'alimentation qui transforme la tension monophasée alternative d'alimentation en provenance de la carte 2 secondaire en une alimentation continue, pour alimenter d'une part un thermostat électronique de faible puissance à deux sorties, et pour alimenter simultanément un bloc formant contacteur de régulation et un bloc formant contacteur de sécurité, ainsi qu'un bloc de présence d'eau et de sécurité anti-dégazage, et enfin un générateur de courant de protection cathodique.

Le bon état de l'accumulateur générant la circulation du courant de protection cathodique entre l'anode et la cuve du chauffe-eau est indiqué par la diode électroluminescente clignotante.

Un contacteur à trois positions permet de sélectionner la marche automatique correspondant à une gestion tarifaire, la marche forcée ou l'arrêt du dispositif pour la mise hors tension du corps de chauffe.

Par rapport au dispositif de gestion électronique du document FR 2.774.153, la carte électronique 1 principale a été perfectionnée par l'ajout d'un fusible supplémentaire dans le bloc d'alimentation. Cet ajout du fusible supplémentaire par rapport au fusible remplaçable par l'installateur permet d'assurer une protection supplémentaire, dans le cas où l'installateur a effectué une mauvaise intervention sur le fusible principal, par exemple en le court-circuitant ou en remplaçant le fusible principal par un fusible de valeur non appropriée. Pour assurer cette mesure de protection supplémentaire, il est prévu que le fusible supplémentaire soit solidaire de la carte électronique 1 principale et ne soit pas remplacé par l'installateur.

Dans le bloc de régulation et de sécurité, deux circuits distincts, un premier circuit de régulation comprenant un potentiomètre de consigne, et un deuxième circuit de sécurité ont été prévus et remplacent le circuit commun de régulation et de sécurité du document FR 2.774.153.

Le deuxième fusible supplémentaire ajouté pour la protection du bloc d'alimentation peut également avantageusement être prévu, comme représenté à la figure 4, au niveau du bloc contacteur de sécurité.

En outre, un bloc supplémentaire a été prévu, assurant une fonction de contacteur jour/nuit pouvant être relancé par un fil pilote non représenté.

Alors que le fonctionnement de la carte électronique 1 principale est sensiblement équivalent du fonctionnement des dispositifs décrits en référence aux figures 3 et 6 du document FR 2.774.453, la carte électronique 2 secondaire est prévue sous forme d'une addition optionnelle pour recevoir une alimentation triphasée en 400 volts, transformer cette alimentation triphasée en 400 volts en une alimentation monophasée de 230 volts destinée à la carte électronique principale 1 pour alimenter toutes les fonctions de cette carte électronique 1 principale. Cependant, au lieu d'alimenter directement la résistance de chauffage du chauffe-eau électrique à accumulation, il est prévu que la sortie de la carte électronique 1 principale soit à nouveau dirigée vers la carte électronique secondaire 2 pour piloter trois relais de gestion de l'alimentation en triphasé de la résistance électrique de chauffage du corps de chauffe.

Pour cette raison, la liaison 9 par connecteur des fils de liaison souples comprend cinq fils de liaison : trois fils destinés à l'alimentation électrique monophasée et deux fils destinés au pilotage des relais de l'alimentation triphasée de la résistance électrique de chauffage non représentée.

## Revendications

1. Dispositif électronique de gestion de chauffe-eau électrique à accumulation, comportant :
- une carte électronique (1) principale;
- une carte électronique (3) de mesure apte à être insérée dans un doigt de gant d'un chauffe-eau auquel le dispositif est destiné,
**caractérisé en ce que** le dispositif comporte, en combinaison, une carte électronique (2) secondaire comprenant des moyens (4) de raccordement à une alimentation électrique triphasée, des moyens de transformation de ladite alimentation électrique triphasée en une alimentation électrique monophasée, et des moyens (9) de connexion à une carte électronique (1) principale reliée à la carte électronique (3) de mesure, de manière à alimenter la carte électronique (1) principale en lui délivrant ladite alimentation électrique monophasée.

2. Dispositif selon la revendication 1,**caractérisé en ce que** les moyens (9) de connexion comportent des moyens de placage de la carte électronique principale (1) et de la carte (2) secondaire l'une contre l'autre.

3. Dispositif selon la revendication 1 ou la revendication 2, comportant des relais (5, 6, 7) de commande d'alimentation triphasée de la résistance de chauffage ou du corps de chauffe d'un chauffe-eau électrique d'accumulation auquel la carte (2) est destinée.

4. Dispositif selon la revendication 3, **caractérisé en ce que** lesdits relais (5, 6, 7) de commande d'alimentation triphasée sont des relais pilotés par un ou plusieurs signaux de commande émis par la carte électronique (1) principale.

5. Dispositif selon l'une quelconque des revendications 1 à 4, **caractérisé en ce que** la carte électronique (1) principale comporte un fusible supplémentaire de protection solidarisé à la carte, pour assurer une protection supplémentaire à la protection assurée par un fusible principal remplaçable.

6. Dispositif selon l'une quelconque des revendications 1 à 5, **caractérisé en ce que** la carte électronique (1) principale comporte un bloc formant contacteur jour/nuit apte à être commandé par un fil pilote.

## Patentansprüche

1. Elektronische Steuervorrichtung für einen elektrischen Warmwasserbereiter mit Speicherung, mit:
- einer elektronischen Hauptkarte (1);
- einer elektronischen Meßkarte (3), die in eine Aufnahme eines Warmwasserbereiters eingesetzt werden kann, für den die Vorrichtung bestimmt ist,
**dadurch gekennzeichnet, daß** die Vorrichtung in Kombination eine zusätzliche elektronische Karte (2) mit Mitteln (4) zum Anschluß an eine dreiphasige Stromversorgung, Mitteln zur Umwandlung der dreiphasigen Stromversorgung in eine einphasige Stromversorgung, und Mitteln (9) zum Anschluß an eine mit der elektronischen Meßkarte (3) verbundene elektronische Hauptkarte (1) umfaßt, damit die elektronische Hauptkarte (1) durch Zuführen der einphasigen Stromversorgung gespeist wird.

2. Vorrichtung nach Anspruch 1, **dadurch gekennzeichnet, daß** die Anschlußmittel (9) Mittel zum dichten Übereinanderlegen der elektronischen Hauptkarte (1) und der zusätzlichen Karte (2) aufweisen.

3. Vorrichtung nach Anspruch 1 oder Anspruch 2, mit Relais (5, 6, 7) zur Steuerung der dreiphasigen Stromversorgung des Heizwiderstandes oder des Heizelementes eines elektrischen Warmwasserbereiters mit Speicherung, für den die Karte (2) bestimmt ist.

4. Vorrichtung nach Anspruch 3, **dadurch gekennzeichnet, daß** die Relais (5, 6, 7) zur Steuerung der dreiphasigen Stromversorgung Relais sind, die über eines oder mehrere Steuersignale, welche von der elektronischen Hauptkarte (1) gesendet werden, gesteuert werden.

5. Vorrichtung nach einem der Ansprüche 1 bis 4, **dadurch gekennzeichnet, daß** die elektronische Hauptkarte (1) eine zusätzliche Sicherung zum Schutz umfaßt, die fest mit der Karte verbunden ist, um einen zusätzlichen Schutz zu dem durch eine austauschbare Hauptsicherung gewährleisteten Schutz sicherzustellen.

6. Vorrichtung nach einem der Ansprüche 1 bis 5, **dadurch gekennzeichnet, daß** die elektronische Hauptkarte (1) eine Baugruppe aufweist, die einen Tag-/Nacht-Schalter bildet, der über eine Steuerleitung gesteuert werden kann.

## Claims

1. Electronic device for controlling an electric storage water heater, comprising:
- a principal electronic board (1);
- an electronic measuring board capable of being inserted in a thimble of a water heater for which the device is intended,
**characterised by** the fact that the device comprises, in combination, a secondary electronic board (2) comprising a means of connection (4) to a three-phase electrical supply, a means for transforming the aforesaid three-phase electrical supply into a single-phase electrical supply and a means of connection (9) to a principal electronic board (1) connected to the electronic measuring board (3) so as to supply the principal electronic board (1) by supplying it with the aforesaid single-phase electrical supply.

2. Device as per claim 1, **characterised by** the fact that the means of connection (9) comprises means for tightly superpositioning the principal electronic board (1) and the secondary board (2) one onto the another.

3. Device as per claim 1 or claim 2, comprising relays (5, 6, 7) for controlling the three-phase electrical supply for the heating resistor or heating element of a storage water heater for which the board (2) is intended.

4. Device as per claim 3, **characterised by** the fact that the aforesaid relays (5, 6, 7) for controlling the three-phase electrical supply are relays controlled by one or more control signals emitted by the principal electronic board (1).

5. Device as per any of the claims 1 to 4, **characterised by** the fact that the principal electronic board (1) comprises an additional protection fuse integrated into the board, to provide additional protection in addition to the protection provided by the main replaceable fuse.

6. Device as per any of the claims 1 to 5, **characterised by** the fact that the principal electronic board (1) comprises a block forming a day/night contactor which can be controlled by a control wire.
